(19) Europäisches Patentamt
European Patent Office
Office européen des brevets

(11) EP 0 486 086 B1

(12) EUROPÄISCHE PATENTSCHRIFT

(45) Veröffentlichungstag und Bekanntmachung des Hinweises auf die Patenterteilung:
05.03.1997  Patentblatt 1997/10

(51) Int Cl.6: **G01R 33/34**, G01R 33/36

(21) Anmeldenummer: 91202846.1

(22) Anmeldetag: 01.11.1991

(54) **Quatraturspulenanordnung**

Quadrature coils system

Dispositif de bobines en quadrature

(84) Benannte Vertragsstaaten:
DE FR GB IT NL

(30) Priorität: 10.11.1990  DE 4035844

(43) Veröffentlichungstag der Anmeldung:
20.05.1992  Patentblatt 1992/21

(73) Patentinhaber:
• **Philips Patentverwaltung GmbH**
**22335 Hamburg (DE)**
Benannte Vertragsstaaten:
**DE**
• **Philips Electronics N.V.**
**5621 BA Eindhoven (NL)**
Benannte Vertragsstaaten:
**FR GB IT NL**

(72) Erfinder: **Leussler, Günther Christoph**
**W-2000 Hamburg 20 (DE)**

(74) Vertreter: **Hartmann, Heinrich, Dipl.-Ing. et al**
**Philips Patentverwaltung GmbH,**
**Röntgenstrasse 24**
**22335 Hamburg (DE)**

(56) Entgegenhaltungen:
EP-A- 0 301 232    EP-A- 0 342 745
DE-A- 4 003 138    US-A- 3 771 055
US-A- 4 837 515

• JOURNAL OF MAGNETIC RESONANCE Band 81, Nr. 1, Januar 1989, Seiten 162-166, Duluth, MN, US; L. BOLINGER et al.: "A Multiple-Frequency Coil with a Highly Uniform B1 Field"

**Beschreibung**

Die Erfindung betrifft eine Quadraturspulenanordnung für ein Kernresonanzuntersuchungsgerät mit zwei zu einer gemeinsamen Symmetrieachse konzentrischen, an einen Hochfrequenzsender und/oder einen Hochfrequenzempfänger anschließbaren, mit ihren Wirkungsrichtungen um 90° gegeneinander versetzten Hochfrequenzspulenanordnungen.

Eine solche Quadraturspulenanordnung ist aus der EP-B 71 896 bekannt. Sie kann zum Empfang von Kernresonanzsignalen und/oder zur Erzeugung von hochfrequenten magnetischen Feldern benutzt werden. Beim Empfang kann damit gegenüber dem Empfang mit nur einer dieser Spulen eine Verbesserung des Signal/Rauschverhältnisses um bis zu 3 dB erreicht werden. Im Sendebetrieb können damit zirkular polarisierte magnetische Hochfrequenzfelder erzeugt werden, wenn den beiden Hochfrequenzspulen Hochfrequenzströme zugeführt werden, die um 90° in der Phase gegeneinander versetzt sind, wodurch sich der Sendeleistungsbedarf halbiert.

Die beiden Hochfrequenzspulenanordnungen sind bei der bekannten Anordnung Sattelspulen, die um 90° gegeneinander verdreht sind, so daß ihre Wirkungsrichtung (das ist die Richtung der von ihnen erzeugbaren Magnetfelder bzw. die Richtung eines Hochfrequenzmagnetfeldes, in der die in der Spule induzierte Spannung ein Maximum hat), ebenfalls um 90° versetzt ist. Die auf den Oberflächen eines zylinderförmigen Trägerkörpers angebrachten Sattelspulen erzeugen Magnetfelder, die zu der Symmetrieachse senkrecht verlaufen. Das in dem Kernresonanzuntersuchungsgsgerät erzeugte stationäre homogene Magnetfeld, das Voraussetzung für die auf magnetischer Kernresonanz basierenden Untersuchungen ist, muß dabei senkrecht zu den Wirkungsrichtungen der beiden Sattelspulen, d.h. in Richtung der Symmetrieachse verlaufen. Da diese bei den Untersuchungen eines Patienten mit der Längsachse des Patienten zusammenfallen muß, muß das Magnetfeld also in Richtung der Längsachse des Patienten verlaufen. Es gibt aber auch Kernresonanzuntersuchungsgeräte, bei denen das stationäre Magnetfeld senkrecht zur Längsachse des Patienten verläuft. Eine hierfür geeignete Untersuchungsanordnung ist in der DE-A 40 03 138 beschrieben. Sie besteht aus einer Solenoidspule, die von einer Spaltresonatorspule umschlossen wird.

Es ist Aufgabe der vorliegenden Erfindung, eine Quadraturspulenanordnung zu schaffen, die sich für Kernspinuntersuchungen eignet, deren homogenes stationäres Magnetfeld senkrecht zur Längsachse eines darin untersuchten Patienten verläuft, und sowohl bei Kopf- oder Extremitätenuntersuchungen als auch bei anderen Untersuchungen einsetzbar ist. Diese Aufgabe wird erfindungsgemäß durch die im Kennzeichen des Hauptanspruchs angegebenen Maßnahmen gelöst.

Nach der Erfindung haben die beiden Hochfrequenzspulenanordnungen, die zusammen die Quadraturspulenanordnung bilden, eine unterschiedliche Bauart. Die erste Hochfrequenzspulenanordnung hat eine zur Symmetrieachse parallele Wirkungsrichtung, während die zweite Hochfrequenzspulenanordnung - vom Bird-Cage-Typ - eine zur Symmetrieachse senkrechte Wirkung hat. Da beide Hochfrequenzspulenanordnungen aber zur Symmetrieachse konzentrisch angeordnet sind, können sie bei entsprechenden Abmessungen auch als Ganzkörperquadraturspule verwendet werden. Durch Drehung der zweiten Hochfrequenzspulenanordnung ist die erfindungsgemäße Quadraturspulenanordnung sowohl bei vertikalem als auch bei horizontalem stationären Magnetfeld anwendbar. Obwohl die zweite Spule vom Bird-Cage-Typ eine im Vergleich zur Sattelspule verbesserte Spulengüte aufweist, tritt die erste Spulenanordnung mit einem in die Quadraturspulenanordnung eingeführten Objekt, z.B. einem Kopf, stärker in Wechselwirkung als die zweite. Dadurch, daß die erste die zweite Hochfrequenzspulenanordnung umschließt, wird erreicht, daß sich die Eigenschaften der beiden Spulenanordnungen einander angleichen, was für die Anwendung innerhalb einer Quadraturspule wichtig ist.

Die Erfindung wird nachstehend anhand der Zeichnung näher erläutert. Es zeigen:

Fig. 1 ein Kernspinuntersuchungsgerät, bei dem die Erfindung anwendbar ist und

Fig. 2 eine Quadraturspulenanordnung nach der Erfindung.

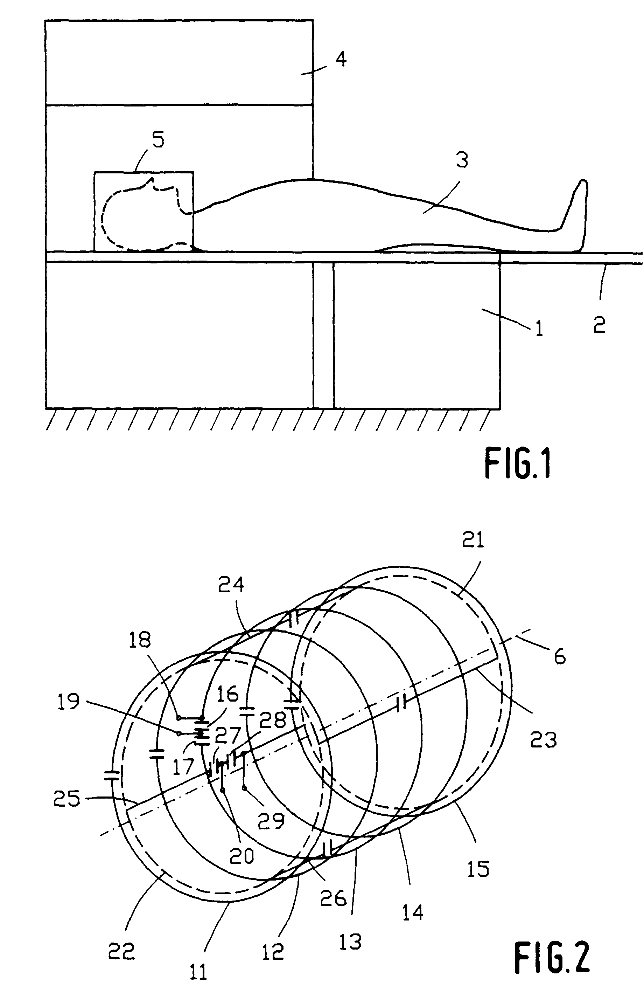

Das in Fig. 1 dargestellte Kernspinuntersuchungsgerät umfaßt u.a. einen Patientenlagerungstisch 1, auf dessen Lagerungsplatte 2 sich ein Patient in horizontaler Lage befindet. Außerdem gehört dazu eine Einheit 4, die den Körper des Patienten mindestens teilweise umschließt. Diese Einheit enthält u.a. einen Magneten zur Erzeugung eines homogenen stationären Magnetfeldes in einem Untersuchungsbereich, in den der Patient einführbar ist. Dieses Magnetfeld kann entweder vertikal oder senkrecht zur Zeichenebene verlaufen - in beiden Fällen also senkrecht zur Längsachse des Patienten. Der Schädel des Patienten wird von einer zylinderförmigen Quadraturspulenanordnung 5 umschlossen, die zur Erzeugung hochfrequenter Magnetfelder und/oder zum Empfang von Kernresonanzsignalen dient.

Wie aus Fig. 2 hervorgeht, besteht die Quadraturspulenanordnung aus zwei Hochfrequenzspulenanordnungen, deren zur Längsachse des Patienten senkrecht verlaufende Wirkungsrichtungen gegeneinander um 90° versetzt sind und die auf die sogenannte Larmorfrequenz f abgestimmt sind. Die Larmorfrequenz f errechnet sich aus der Magnetflußdichte B des homogenen stationären Magnetfeldes nach der Beziehung

$$f=cB,$$

wobei c das gyromagnetische Verhältnis ist, das für Protonen 42,5 mHz/T beträgt. Im Sendebetrieb werden den beiden Hochfrequenzspulenanordnungen Hochfrequenzströme mit der Larmorfrequenz zugeführt, die in der Phase um 90° gegeneinander versetzt sind.

In Fig. 2 ist die Quadraturspulenanordnung schematisch dargestellt, wobei die Leiterschleifen der zweiten Hochfrequenzspulenanordnung der Übersichtlichkeit halber gestrichelt dargestellt sind.

Die erste Hochfrequenzspulenanordnung umfaßt eine Anzahl von Leiterschleifen 11..15, die sich in gleichmäßigem Abstand voneinander in parallelen Ebenen befinden. Die Leiterschleifen 11..15 haben Kreisform und sind konzentrisch bezüglich einer Symmetrieachse 6 angeordnet, die bei Verwendung der Spule in Längsrichtung des Patienten verläuft. In jede Leiterschleife ist wenigstens ein Kondensator aufgenommen, so daß jede Leiterschleife ein Teil jeweils eines Resonators bildet. Diese Resonatoren sind lediglich induktiv miteinander gekoppelt. Die erste Hochfrequenzspulenanordnung zeigt soviele Schwingungsmoden, wie es Resonatoren gibt. Bei dem Schwingungsmodus mit der niedrigsten Resonanzfrequenz fließen die Ströme in allen Resonatoren mit gleichem Umlaufsinn. In diesem Schwingungsmodus wird die erste Hochfrequenzspulenanordnung betrieben. In eine der Leiterschleifen - die Leiterschleife 13 - sind zwei in Serie geschaltete Kondensatoren 16 bzw. 17 aufgenommen, wobei die Anschlüsse 18 und 19 des einen Kondensators (16) an den Ausgang eines Hochfrequenzsenders bzw. an den Eingang eines Hochfrequenzempfängers anschließbar sind.

Eine derartige Hochfrequenzspulenanordnung ist aus der DE-A 3816831 bekannt; auf diese Veröffentlichung wird ausdrücklich Bezug genommen.

Die zweite Hochfrequenzspulenanordnung ist ein sogenannter bird-cage-"Resonator. Derartige Resonatoren sind aus der EP-B 141 383 bekannt. Der Resonator umfaßt zwei gestrichelt angedeutete, die Symmetrieachse 6 konzentrisch umschließende kreisförmige Leiterschleifen 21 und 22. Diese befinden sich vorzugsweise in der gleichen Ebene wie die beiden äußersten Leiterschleifen 11 und 15 und haben einen geringfügig kleineren Durchmesser als diese. Sie sind über vier zur Symmetrieachse 6 parallele Leiter 23-26 miteinander verbunden, von denen jeder wenigstens einen Kondensator enthält. Der Leiter 25, der an den Ausgang eines Hochfrequenzsenders oder den Eingang eines Hochfrequenzempfängers angeschlossen ist, enthält zwei gleichgroße in Serie geschaltete Kondensatoren 27 und 28, wobei das Signal an den Klemmen 20 und 29 des einen Kondensators (28) abgenommen wird. Bei Anschluß an einen Hochfrequenzsender ergibt sich dadurch ein Magnetfeld, das senkrecht zur Symmetrieachse 6 in einer die Leiter 24 und 26 enthaltenden Ebene verläuft; demgegenüber erzeugt die erste Hochfrequenzspulenanordnung bei Anschluß an einen Hochfrequenzsender ein Magnetfeld, das in Richtung der Symmetrieachse 6 verläuft.

Die beiden Hochfrequenzspulenanordnungen sind geometrisch und elektrisch aneinander angepaßt. Die Länge der beiden Spulen, das ist der Abstand der Ebenen, in denen sich die beiden Leiterschleifen 21 und 22 bzw. die beiden äußersten Leiterschleifen 11 und 15 befinden, beträgt bei Verwendung als Kopfspule beispielsweise 25 cm, während der Innendurchmesser der Quadraturspulenanordnung für diesen Zweck beispielsweise 30 cm beträgt. - Damit die Vorteile einer Quadraturspulenanordnung erreicht werden können, muß das elektrische Verhalten der beiden unterschiedlichen Quadraturspulen möglichst identisch sein. Das bedeutet beispielsweise, daß bei Anlegen gleich großer Spannungen an die Anschlüsse 20, 29 bzw. 18, 19 im Untersuchungsbereich gleich starke hochfrequente Magnetfelder erzeugt werden müssen. Dazu sollte die erste Hochfrequenzspulenanordnung anstelle der fünf dargestellten Leiterschleifen acht Leiterschleifen enthalten und die zweite Hochfrequenzspulenanordnung anstelle der vier Leiter 23..26 zwölf gleichmäßig auf den Umfang der Leiterschleifen 21 und 22 verteilte Leiter. Außerdem sollte - wie in Fig. 2 dargestellt - die erste Hochfrequenzspulenanordnung die zweite umschließen, weil sie mit einem in die Quadraturspulenanordnung eingeführten Objekt, z.B. einem Kopf, stärker in Wechselwirkung tritt als die zweite.

Wie bereits erwähnt, stehen die Wirkungsrichtungen der beiden Hochfrequenzspulenanordnungen senkrecht zueinander. Bei exakt symmetrischem Aufbau sind sie daher voneinander entkoppelt, d.h. ein von der einen Spule erzeugtes Hochfrequenzmagnetfeld erzeugt in der anderen Spule kein Signal. In der Praxis ergeben sich jedoch aufgrund unvermeidlicher Unsymmetrien Kopplungen zwischen den beiden Spulen, die - bei Verwendung als Empfangsspulen - das Signal-Rauschverhältnis der Quadraturspulenanordnung beträchtlich verringern. Diese Kopplungen lassen sich aber gemäß der DE-OS 38 20 168 mit Hilfe eines einstellbaren Kondensators beseitigen, der die beiden Spulenanordnungen so miteinander verbindet, daß der durch die magnetische Kopplung verursachte Strom durch den über den Kondensator von dem einen Spulensystem zum andern fließenden Strom kompensiert wird. Dazu wird der einstellbare Kondensator einerseits z.B. mit der vom Verbindungspunkt der Kondensatoren 16 und 17 abgewandten Anschlußklemme 18 verbunden und andererseits mit der entsprechenden Klemme 29 der zweiten Spulenanordnung. Wird dadurch die magnetische Kopplung verstärkt, dann wird dieser Kondensator mit dem freien Anschluß des Kondensators 27 (statt mit der Klemme (29) oder mit dem entsprechenden Anschluß des Kondensators (17) (statt mit der Klemme (18) verbunden.

## Patentansprüche

1. Quadraturspulenanordnung für ein Kernresonanzuntersuchungsgerät mit zwei zu einer gemeinsamen Symmetrieachse konzentrischen, an einen Hochfrequenzsender und/oder einen Hochfrequenzempfänger anschließbaren, mit ihren Wirkungsrichtungen um 90° gegeneinander versetzten Hochfrequenzspulenanordnungen, dadurch gekennzeichnet, daß die erste Hochfrequenzspulenanordnung mehrere lediglich induktiv miteinander gekoppelte, in bezug auf die Symmetrieachse (6) gegeneinander versetzte ringförmige Leiterschleifen (11...15) enthält, daß die zweite Spulenanordnung in zur Symmetrieachse (6) senkrechten, zueinander parallelen Ebenen die Symmetrieachse bogenförmig umschließende Leiterschleifen (21,22) enthält, die über zur Symmetrieachse parallele Leiter (23-26) miteinander verbunden sind, wobei in den zwischen jeweils zwei benachbarten Leitern befindlichen Abschnitten der Leiterschleifen und/oder in den Leitern Reaktanzelemente enthalten sind, und daß die erste Hochfrequenzspulenanordnung die zweite Hochfrequenzspulenanordnung umschließt.

## Claims

1. A quadrature coil system for a magnetic resonance examination apparatus, comprising two high-frequency coil systems which are concentric with respect to a common symmetry axis and can be connected to a high-frequency transmitter and/or a high-frequency receiver, their field directions enclosing an angle of 90° with respect to one another, characterized in that the first high-frequency coil system comprises a plurality of annular conductor loops (11 ... 15) which are merely inductively coupled to one another and are mutually offset relative to the symmetry axis (b), that the second coil system comprises conductor loops (21, 22) which are arranged in parallel planes extending perpendicularly to the symmetry axis (6), and enclose the symmetry axis arc-like, which loops are interconnected *via* conductors (23 - 26) extending parallel to the symmetry axis, reactance elements being provided in the segments of the conductor loops situated between each time two neighbouring conductors, or in the conductors, and that the first high-frequency coil system encloses the second high-frequency coil system.

## Revendications

1. Montage de bobines en quadrature pour un appareil d'examen par résonance magnétique nucléaire comportant deux montages de bobines haute fréquence concentriques par rapport à un axe de symétrie commun, pouvant être connectés à un émetteur haute fréquence et/ou à un récepteur haute fréquence, et dont les directions d'action sont décalées l'une par rapport à l'autre de 90°, caractérisé en ce que le premier montage de bobine haute fréquence contient plusieurs boucles conductrices circulaires (11...15) couplées les unes aux autres uniquement par induction et décalées les unes par rapport aux autres sur l'axe de symétrie (6), que le deuxième montage de bobine contient, dans des plans perpendiculaires à l'axe de symétrie (6) et parallèles les uns aux autres, des boucles conductrices (21, 22) qui entourent en forme d'arc l'axe de symétrie et qui sont connectées l'une à l'autre par l'intermédiaire de conducteurs (23 à 26) parallèles à l'axe de symétrie, sachant que les segments des boucles conductrices se trouvant chaque fois entre deux conducteurs voisins et/ou les conducteurs contiennent des éléments à réactance, et que le premier montage de bobine haute fréquence entoure le deuxième montage de bobine haute fréquence.

FIG.1

FIG.2